# EUROPÄISCHE PATENTSCHRIFT

(11) **EP 1 482 774 B1**
(45) Veröffentlichungstag und Bekanntmachung des Hinweises auf die Patenterteilung: **27.09.2006**
(21) Anmeldenummer: 04007977.4
(22) Anmeldetag: 01.04.2004
(51) Int. Cl.: H05K 9/00

(54) **Elektronisches Gerät mit einer abgeschirmten Kammer**
Electronic device with a shielded enclosure
Appareil électronique avec une chambre blindée

(30) Priorität: 28.05.2003 DE 10324411
(43) Veröffentlichungstag der Anmeldung: 01.12.2004
(73) Patentinhaber: Kathrein Werke KG, 83022 Rosenheim (DE)
(72) Erfinder: Häntsch, Ralf, 83064 Raubling (DE); Meishammer, Adalbert, 83026 Rosenheim (DE); Schmied, Bernhard, 83026 Rosenheim (DE)
(74) Vertreter: Flach, Dieter Rolf Paul

(56) Entgegenhaltungen:
- EP-A- 0 959 652
- DE-A1- 4 317 469
- US-A- 5 014 160
- US-A- 5 160 807

## Beschreibung

Die Erfindung betrifft ein elektronisches Gerät nach dem Oberbegriff des Anspruches 1.

Insbesondere in der Hochfrequenztechnik, beispielsweise bei Geräten für die Mobilfunktechnik, kommen Geräte zum Einsatz, die entsprechend hochfrequenzmäßig dicht ausgestattet sein sollen und müssen. Dabei benötigen die entsprechenden Geräte häufig noch Transformator-Einrichtungen oder dergleichen.

Um eine hochfrequenzmäßig dichte Abschirmung der elektronischen Komponenten eines elektrischen Gerätes von anderen Komponenten wie beispielsweise einem Transformator zu erzielen, ist eine der möglichen Varianten, den Transformator in einem externen Gehäuse außerhalb des geschirmten HF-Gerätes unterzubringen.

Andererseits wäre es auch aus Gründen der Erhöhung der Integrationsdichte und zur Herstellung einfacherer Gehäuse wünschenswert, eine Leiterplatine mit den elektronischen und elektrischen Komponenten mit einem Trafo oder sonstigen abzuschirmenden Komponenten in einem gemeinsamen hochfrequenzdichten Gehäuse unterbringen zu können, ohne dass im Inneren nachteilige Wechselwirkungen zu befürchten sind.

Von daher ist bereits vorgeschlagen worden, in einem HF-mäßig abgedichteten Gehäuse noch eine weitere Abschirmeinrichtung zu integrieren, in der beispielsweise durch Seitenwände und einen zusätzlichen Abschirmdeckel ein oder mehrere Kammern nochmals HF-mäßig von anderen Bereichen innerhalb des HF-dichten Gehäuses abgeschirmt sind. Dazu müssen allerdings beispielsweise auf der Leiterplatine zur Abgrenzung solcher zusätzlich abgeschirmter Kammern separate Wände und ein Abschirmdeckel einzeln vorgesehen und montiert werden, was vergleichsweise aufwendig ist. Gleichwohl bleibt noch das Problem bestehen, dass über die Leiterplatine die Unterseite HF-mäßig nicht von anderen Bereichen des Innenraumes des Gehäuses abgeschirmt ist.

Eine dem vorstehenden Stand der Technik weitgehend entsprechende Abschirmeinrichtung ist aus der EP 0 813 805 B1 bekannt. Gezeigt ist ein abgeschirmtes Gehäuse mit mehreren Kammern, wodurch die auf einer darunter befindlichen Leiterplatine vorgesehenen elektrischen Baugruppen und Baukomponenten voneinander abgeschirmt werden sollen.

Aus der US 5 160 807 A ist ebenfalls ein elektronisches Gerät mit einer Leiterplatine bekannt geworden, wobei zur Schirmung eines Teils der elektrischen Baukomponenten auf der Leiterplatine eine zusätzliche Abschirmgehäuse-Einrichtung vorgesehen ist. Dazu weist die Leiterplatine mehrere schlitzförmige Ausnehmungen auf, so dass eine erste Gehäusehälfte mit am unteren Umfangsrand verlaufend ausgebildeten, nach unten vorstehenden Zungen so aufgesetzt werden kann, dass die zungenförmigen Vorsprünge durch die Ausnehmung der Leiterplatine nach unten hin hindurchragen können. Eine insoweit weitgehend vergleichbare zweite Schirmungshälfte kann in umgekehrter Ausrichtung von unten her auf die Leiterplatine aufgesetzt werden, und zwar derart, dass die auch an der unteren als Schirmung dienenden Gehäusehälfte ausgebildeten, nunmehr aber nach oben weisenden Vorsprünge oder Zungen ebenfalls in die schlitzförmigen Ausnehmungen der Leiterplatine eingesteckt werden können, so dass nunmehr wechselweise die von oben nach unten durch die Ausnehmung der Leiterplatine ragenden zur oberen Gehäusehälfte gehörenden Zungen benachbart neben den von unten nach oben durch die Ausnehmung der Leiterplatine und zur unteren Schirmungshälfte gehörenden leitfähigen Zungen aneinander liegen.

Aufgabe der vorliegenden Erfindung ist es, ausgehend von dem zuletzt genannten Stand der Technik , ein verbessertes elektronisches Gerät zu schaffen, welches mit einfachen Mitteln einen im Inneren des elektronischen Gerätes vorgesehenen zusätzlichen hochfrequenzmäßig abgeschirmten Bereich schafft.

Die Aufgabe wird erfindungsgemäß entsprechend den im Anspruch 1 bzw. Anspruch 2 angegebenen Merkmalen gelöst.

Durch die vorliegende Erfindung wird ein elektronisches Gerät mit einer beidseitig der Leiterplatine liegenden Abschirmkammer geschaffen, die zudem leicht demontierbar ist. Die gegenüber den verbleibenden Bereichen der elektronischen Baukomponenten zusätzlich geschirmte Kammer kann mit geringsten Kosten hergestellt werden. Von daher lässt sich eine höchst einfache Montage realisieren, die jederzeit auch eine Demontage ermöglicht. Nach dem Entfernen der Abschirmhaube und dem Ausbau der Leiterplatine sind auch die auf der Leiterplatinen-Unterseite befindlichen Bauteile und Baugruppen sehr schnell und leicht zugänglich, was insbesondere für den Servicefall Vorteile aufweist. Dabei ist für die Schirmung der Leiterplatinen-Oberseite und der Leiterplatinen-Unterseite nur eine zusätzliche Abschirmhaube notwendig. Diese besteht bevorzugt aus einem einzigen Teil.

Die Abschirmhaube ist wie im gattungsbildenden Stand der Technik so ausgebildet, dass sie zumindest mit einer Wand oder einem Wandabschnitt die Leiterplatine durchdringen kann. Dazu weist die Abschirmhaube zumindest eine Seitenwand oder einen Abschnitt einer Seitenwand nach Art zumindest eines Vorsprunges auf, vorzugsweise durch eine Reihe von versetzt zueinander liegenden Vorsprüngen, deren maximaler Abstand so gewählt ist, dass die gewünschte Schirmung entsprechend den zur Anwendung gelangenden Frequenzen oder Wellenlängen ausreichend ist. Die bevorzugte zungen-, stab- oder stiftförmigen an der Abschirmhaube ausgebildeten und versetzt zueinander liegenden Vorsprünge, die dann beim Aufsetzen auf die Leiterplatine durch in der Leiterplatine an entsprechenden Stellen vorgesehenen Ausnehmungen hindurch geführt werden, kontaktieren so auf der Leiterplatinen-Unterseite die dort ausgebildeten Gegenkontaktstellen des geschirmten Gehäuses, die nachfolgend auch als Kontakt-Gegenstücke bezeichnet werden und die im Inneren des Gehäuses liegende Wandabschnitte bilden, die der weiteren Abschirmung eines Kammerraumes im Gehäuseinneren dienen.

Die verbleibenden Wände oder Wandabschnitte, die die Leiterplatine nicht durchdringen, können direkt mit entsprechenden Wandabschnitten des die Abschirmhaube mit aufnehmenden Gehäuses des Gerätes kontaktiert werden.

Im Sinne einer Umkehrung des Kontaktierungsprinzipes kann aber auch auf der Leiterplatinenunterseite eine Vielzahl von nach oben vorstehenden Vorsprüngen, vorzugsweise zungenförmigen Vorsprüngen etc. ausgebildet sein, die ebenfalls durch entsprechende Ausnehmungen in einer aufgesetzten Leiterplatine bis zur Leiterplatinen-Oberseite hin vorstehen, um dort mit der aufgesetzten Abschirmhaube elektrisch kontaktiert zu werden. Die erwähnten Vorsprünge sind dabei Teil des Gehäuses und gehen bevorzugt von auf der Unterseite der Leiterplatine ausgebildeten Wänden oder Wandabschnitten nach oben vorstehend aus, wobei diese Wandabschnitte der zusätzlichen Abschirmung des Raumes unterhalb der Abschirmhaube auch auf der Leiterplatinen-Unterseite dient.

In einer bevorzugten Ausführungsform der Erfindung kann dabei die Abschirmkammer so ausgebildet sein, dass nur eine Seite oder ein Teilabschnitt der Abschirmkammer die Leiterplatine durchdringt, oder aber dass zwei Seiten, drei Seiten oder bei rechteckförmiger Ausführung beispielsweise vier Seiten oder allgemein alle Seiten der Abschirmkammer mit entsprechenden Vorsprüngen versehen sind, die die erwähnten Ausnehmungen der Leiterplatine durchdringen und auf der Leiterplatinen-Unterseite mit dem Gehäuse kontaktiert sind. Genauso kann auch dieses Prinzip insoweit abgewandelt oder teilweise ergänzt werden, dass zwei, drei, vier oder alle Seiten des Abschirmgehäuses mit von der Gehäuseinnenseite ausgehenden, die Leiterplatine durchdringenden Vorsprüngen kontaktierbar sind.

Die Vorsprünge, die durch die entsprechende Ausnehmung der Leiterplatine hindurchragen, sind bevorzugt zungenförmig, d.h. allgemein laschenförmig, stiftförmig, stabförmig, kammförmig etc. ausgebildet. Eine elektrisch gute Kontaktierung kann durch unterschiedliche Maßnahmen realisiert werden. Beispielsweise können die zungen-, laschen-, stift- oder stabförmigen oder sonstig geformten Vorsprünge, die den einen Kontakt herstellen, mit Gegenkontakt-Stellen (wie diese beispielsweise auf der Gehäuseinnenseite oder auf Wandabschnitten an der Gehäuseinnenseite ausgebildet sind) dadurch elektrisch optimal kontaktiert werden, dass die Zungen beispielsweise in entsprechende Ausnehmungen oder Aufnahmen an den Gegenkontakt-Stellen beim Zusammenfügen eindringen und dabei entsprechend mechanisch druckbelastet verformt, eingekerbt etc. werden. Optimal ist beispielsweise beim Zusammenfügen eine leichte Verdrehung eines zungenförmigen Kontaktes, wenn dieser in eine schlitzförmige Ausnehmung eines Gegenkontaktes eingesteckt wird. Ein guter Kontakt ist allerdings auch durch andere Maßnahmen realsierbar, indem z.B. die gesamte Zunge in eine Richtung quer zur Zungenebene ausgelenkt wird. Benachbarte Zungen können beispielsweise in die Gegenrichtung ausgelenkt werden etc.

Soweit Wände oder Wandabschnitte der Abschirmhaube die Leiterplatine nicht durchdringen, ist es ausreichend, wenn die Wände in Steckrichtung mit einem mehr oder weniger gerade verlaufenden Begrenzungsrand versehen sind. Die so gebildeten Wände oder Wandabschnittes der Abschirmhaube können dann aber mit entsprechenden gehäuseinnenseitigen Klemmmechanismen oder Kontaktmechanismen zusammenwirken, um auch hier eine optimale elektrische Kontaktierung zwischen Abschirmhaube und leitendem Außengehäuse des Gerätes herzustellen.

Das erfindungsgemäße elektronische Gerät mit der zusätzlich vorgesehenen, oberhalb und unterhalb der Leiterplatine ausgebildeten, zumindest einen Abschirmkammer (oder mehrere Abschirmkammern bei Bedarf), eignet sich für die unterschiedlichsten Anwendungsfälle.

Insbesondere eignet sich dieses erfindungsgemäße elektronische Gerät zur Aufnahme eines zusätzlichen Netzteiles und zusätzlich vorgesehen Abschirmkammern. Dadurch ist es nicht länger notwendig, eine getrennte Leiterplatine für das Netzteil zum einen und für die HF-Schaltung zum anderen zu verwenden. Netzteil und beispielsweise Verstärkerbauteile können somit auf einer einzigen Leiterplatine vorgesehen sein, wobei jener Abschnitt der Leiterplatine, in welchem das Netzteil angeordnet oder vorgesehen ist, durch die zusätzliche Abschirmhaube geschirmt wird. Bevorzugt ist in diesem Falle in einer Wandung der Abschirmhaube eine vorzugsweise gering dimensionierte, d.h. zumindest für die Durchführung des Kabels ausreichende Öffnung vorgesehen, wobei Leitungen zwischen Netzteil und HF-Schaltung bevorzugt mit Durchführungsfiltern versehen werden, um die Störfestigkeit zu erhöhen.

Ein auf das gesamte Gehäuse aufsetzbarer Deckel überdeckt dabei nicht nur die HF-Komponenten des elektronischen Gerätes, sondern zusätzlich auch noch die Abschirmhaube mit dem darunter befindlichen Netzteil.

Auch an dem Netzkabeleingang oder sonstigen Kabeldurchführungen können zusätzliche Kontaktpunkte vorgesehen sein, um die Abschirmwirkung zu erhöhen. Eine derartige Ausbildung bietet auch den Vorteil, dass selbst bei abgenommenem Deckel des elektronischen Gerätes die Abschirmhaube immer noch ihre Funktion erfüllt, insbesondere dann, wenn sich darunter das erwähnte Netzteil befindet. Denn der Rest der auf der bevorzugt gemeinsamen Platine vorgesehenen HF-Schaltung ist durch die Abschirmhaube weiter abgeschirmt. Es können auch bei abgenommenem Deckel des elektrischen Gerätes Einstellarbeiten am Gerät durchgeführt werden.

Die Abschirmhaube wird bevorzugt aus einem Blechteil hergestellt, und zwar bevorzugt als einteiliges Stanzteil. Durch Abwinkeln von vier Seitenwänden kann aus einem derartigen Stanzteil eine rechteckförmige Abschirmhaube hergestellt werden. Um eine gute Kontaktierung zwischen den zur Deckelfläche um 90° gebogenen Seitenwänden der Abschirmhaube zu ermöglichen, kann dort an den einzelnen Seitenwänden jeweils an ihren Randabschnitten benachbart zur nächsten Seitenwand eine Lasche ausgebildet sein, die über den Trennungsschlitz zur benachbarten Seitenwand herumgelegt und mit der benachbarten Seitenwand elektrisch leitend verbunden wird. Die so ausgebildete und zur nächsten Seitenwand jeweils umgelegte Lasche, Zapfen oder dergleichen kann die elektrische Verbindung durch die Umlegung, durch Verdrillen, durch Stanznieten etc. zum benachbarten Seitenwandabschnitt der Abschirmhaube gewährleisten. Natürlich kann die Abschirmhaube auch beispielsweise durch Tiefziehen hergestellt sein.

Die Erfindung wird nachfolgend anhand von Ausführungsbeispielen näher erläutert. Dabei zeigen im Einzelnen:
- Figur 1:: eine perspektivische Ansicht des Gehäuses des erfindungsgemäßen elektronischen Gerätes mit einem wannenförmigen Gehäuseunterteil und einem Deckel;
- Figur 2:: eine entsprechende Darstellung zu Figur 1 bei abgenommenem Deckel;
- Figur 3:: eine zu Figur 2 entsprechende Darstellung bei abgenommener Abschirmhaube;
- Figur 4:: eine entsprechende Darstellung zu Figur 3 bei entfernter Leiterplatine;
- Figur 5a:: eine perspektivische separate Darstellung der Abdeckhaube von ihrer Oberseite her;
- Figur 5b:: eine entsprechende Darstellung zu Figur 5a, jedoch in perspektivischer Darstellung der Unterseite der Abschirmhaube;
- Figur 6:: eine auszugsweise vergrößerte perspektivische Darstellung einer gehäuseseitigen Kontaktstelle;
- Figur 7:: eine teilweise perspektivische Darstellung der gehäuseseitigen Kontaktstellen im Inneren des Gehäuses;
- Figur 8:: eine teilweise Darstellung in Draufsicht auf das Gehäuse und die gehäuseseitigen Kontaktstellen sowie weitere Kontaktstellen zur Schirmung von anderen Teilen der Seitenwände der Abschirmhaube;
- Figur 9:: eine perspektivische Darstellung vergleichbar Figur 4, bei welcher jedoch abgewandelte gehäuseseitige Kontaktstellen vorgesehen sind,
- Figur 10:: eine vergrößerte Detaildarstellung der in Figur 9 wiedergegebenen Kontaktstellen;
- Figur 11:: eine alternative Ausführungsform, bei der die gehäuseseitigen Kontaktstellen mit durch die Leiterplatine nach oben vorstehenden Kontakt-Vorsprüngen versehen sind;
- Figur 12:: eine perspektivische Darstellung vergleichbar Figur 2 mit einem Abschirmgehäuse, dessen vier Seitenwände die Leiterplatine durchdringen;
- Figur 13:: eine zu Figur 12 entsprechende Darstellung bei abgezogener Abschirmhaube; und
- Figur 14:: eine vergrößerte Teildarstellung, bei der gegenüber Figur 13 auch die Leiterplatine aus dem Gehäuse 1 entfernt ist.

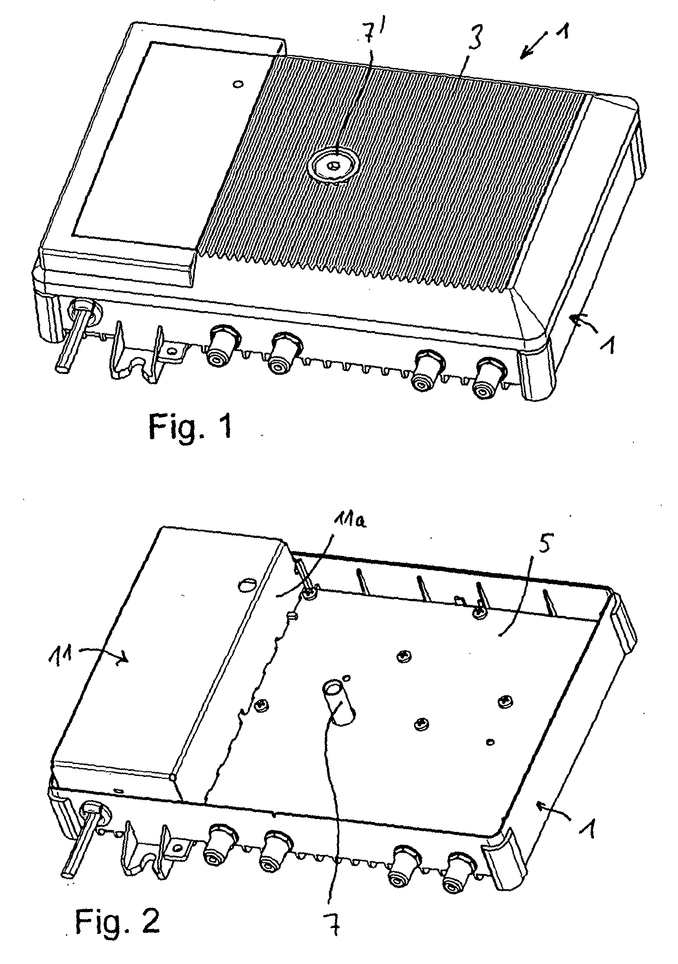

In Figur 1 ist in schematischer perspektivischer Darstellung ein erfindungsgemäßes elektrisches bzw. elektronisches Gerät gezeigt, welches eine Gehäuseanordnung mit einem Gehäuse 1 und mit einem das Gehäuse 1 abschließenden Deckel 3 umfasst. Zumindest das Gehäuse 1, vorzugsweise aber auch der Deckel 3, bestehen aus Gussmaterial, vorzugsweise Metallguss, oder sind zumindest mit einer elektrisch leitenden Fläche bzw. Oberfläche, zumindest auf der Gehäuseinnenseite versehen.

In Figur 2 ist eine entsprechende perspektivische Darstellung zu Figur 1 in Teilansicht bei abgenommenem Deckel 3 wiedergegeben. Dabei ist zu erkennen, dass in dem wannenförmigen Innenraum des Gehäuses 1 eine Leiterplatine 5 untergebracht ist, auf deren Oberseite und/oder Unterseite eine Vielzahl von elektrischen Leitungen sowie elektronischen aktiven und passiven Bauelementen und Baukomponenten vorgesehen sein können. Eine die Platine 5 im mittleren Bereich durchsetzende Säule 7 dient lediglich dazu, den in Figur 1 ersichtlichen Deckel mittels einer von oben her einzudrehenden Schraube 7' mit der Gehäuseunterseite, d.h. allgemein dem Gehäuse 1, fest zu verbinden.

Aus Figur 2 ist ersichtlich, dass im Innenraum der Gehäuseanordnung ferner noch eine Abschirmhaube 11 vorgesehen ist, wobei darin beispielsweise ein vom restlichen Innenraum der Gehäuseanordnung abzuschirmender Transformator, ein Netzteil oder eine sonstige elektrische Komponente untergebracht sein kann. Die Abschirmhaube 11 ist deshalb auch elektrisch leitend und besteht bevorzugt aus einem Blech-Stanzteil.

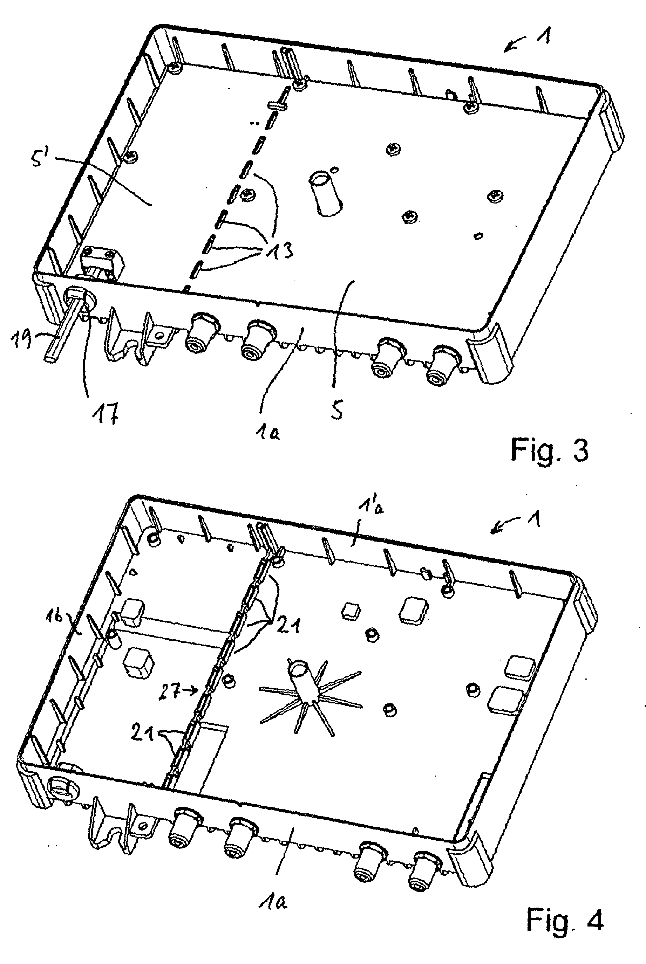

Wird gemäß Figur 3 die in Figur 2 sichtbare Abschirmhaube 11 nach oben hin senkrecht von der Leiterplatine 5 abgezogen, so liegt auch der Teil 5' der Leiterplatine 5 frei, der sich unter der Abschirmhaube 11 befindet. Die auch dort vorgesehenen elektrischen Bauteile und Komponenten oder Transformatoren etc. sind der Einfachheit halber in Figur 3 nicht dargestellt.

Zu sehen sind allerdings eine Reihe von Ausnehmungen 13 in der Leiterplatine 5, die im gezeigten Ausführungsbeispiel schlitzförmig gestaltet sind. Die Ausnehmungen 13 sind in der Leiterplatine an der Stelle angeordnet, an welcher die in Figur 2 sichtbare, zum größeren Teil der Leiterplatine 5 benachbart liegende Seitenwand 11a der Abschirmhaube 11 im montierten Zustand zu liegen kommt.

Sofern zuvor das in Figur 3 an der vorderen Seitenwand 1a des kastenförmigen Gehäuses 1 durch eine Öffnung 17 ins Innere hineingeführte Netzanschlusskabel 19 sowie alle Befestigungsschrauben entfernt sind, kann bei zuvor abgenommener Abschirmhaube 11 gemäß der Darstellung nach Figur 3 die gesamte Leiterplatine 5 nach oben hin abgehoben, d.h. aus dem kastenförmigen Gehäuse 1 entfernt werden, so dass sich dann der gemäß Figur 4 nach innen freie Blick auf den Boden des kastenförmigen Gehäuses 1 ergibt.

Gemäß der Darstellung nach Figur 4 ist zu ersehen, dass unterhalb der schlitzförmigen Ausnehmungen 13 der Leiterplatine 5 Kontakt-Gegenstücke 21 ausgebildet sind, die dazu dienen, eine Kontaktierung durch die Leiterplatine 5 hindurch zwischen der Abschirmhaube 11 und den durch die Kontakt-Gegenstücke 21 gebildeten Kontaktstellen 21a des Gehäuses 1 zu gewährleisten.

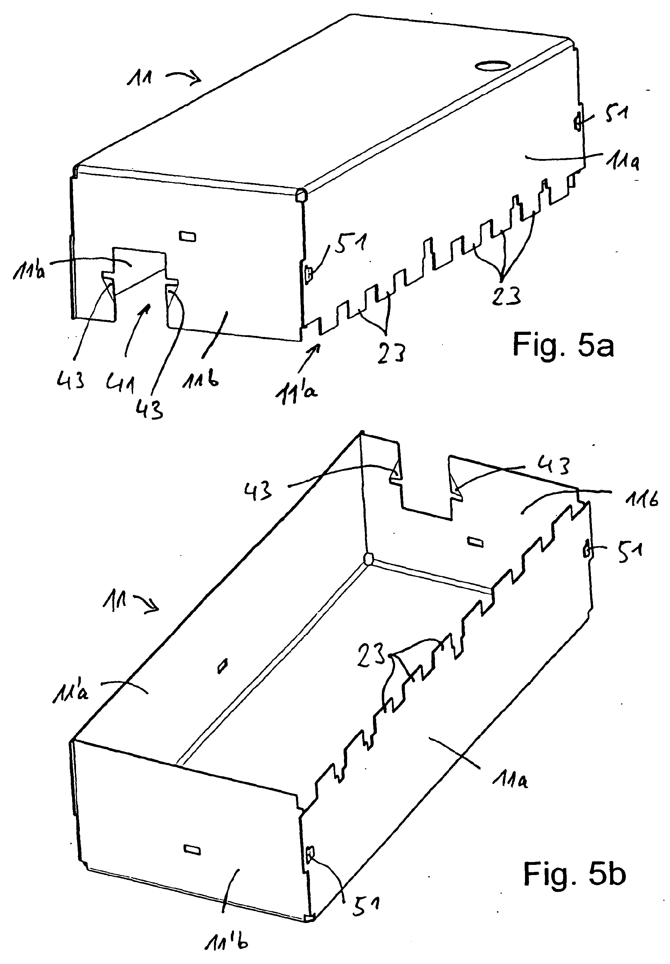

Dazu wird insbesondere auch auf die Figuren 5a und 5b verwiesen, in welchen die abgezogene Abschirmhaube 11 in perspektivischer Ober- bzw. Unteransicht zu sehen ist. Aus den Figuren 5a und 5b ist zu entnehmen, dass die Seitenwand 11a der Abschirmhaube 11 im Bereich ihrer Unter- oder Steckseite 11'a mit einer Vielzahl in Längsrichtung der Seitenwand 11a versetzt zueinander liegenden Vorsprüngen 23 versehen ist. Diese nachfolgend teilweise auch als Kontakt-Vorsprünge 23 bezeichneten Vorsprünge 23 weisen bevorzugt eine gewisse Längserstreckung sowie eine geeignete Wiederholungsrate auf, um eine gute Schirmung zu erzielen. In montiertem Zustand wird dabei die Abschirmhaube 11 bei zuvor im Gehäuse 1 eingefügter Leiterplatine 5 so aufgesetzt, dass die in den Figuren 5a und 5b ersichtlichen Kontakt-Vorsprünge 23 durch die schlitzförmigen Ausnehmungen 13 in der Leiterplatine 5 hindurch geführt werden und mit den einen Teil des Gehäuses 1 darstellenden Kontakt-Gegenstücken 21 kontaktiert sind.

Im gezeigten Ausführungsbeispiel bei schlitzförmigen oder laschenförmigen Vorsprüngen 23 an der Abschirmhaube 11 sind die gehäuseseitigen Kontakt-Gegenstücke 21 als schlitzförmige Aufnahme-Kontaktstellen 21a ausgebildet.

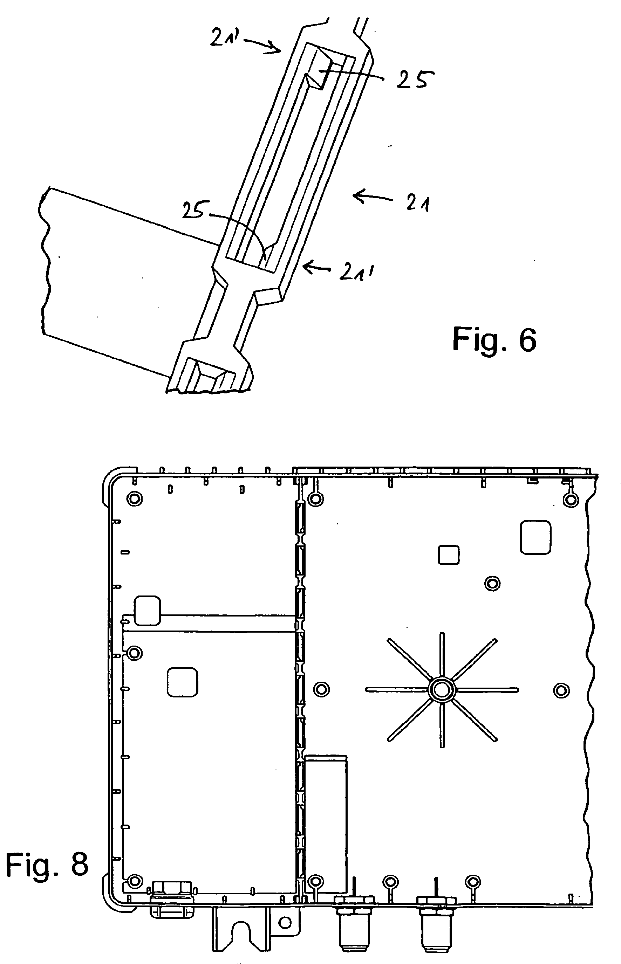

Um eine besonders gute Kontaktwirkung zu erzielen, weisen die Aufnahme-Kontakt-Gegenstücke 21 zusätzliche Maßnahmen auf, wie dies aus der vergrößerten, perspektivischen Teildarstellung gemäß Figur 6 zu ersehen ist. Daraus lässt sich entnehmen, dass die schlitzförmigen Kontakt-Gegenstücke 21 jeweils an ihren gegenüberliegenden Enden 21' mit von oben nach unten keilförmigen Auflauf- und Klemmflächen 25, also rampenförmigen Klemmflächen 25, versehen sind, die bevorzugt an ihrem unteren, also breitesten Bereich am Boden der schlitzförmigen Kontaktstellen 21 zumindest so nahe an die Mittellängsfläche der schlitzförmigen Aufnahme 21' oder sogar über diese Ebene hinaus ragen, dass bei eingeschobenen flächigen oder plattenförmigen Kontakt-Vorsprüngen 23 der Abschirmhaube 11 diese zumindest in einem kleinen Winkelbereich um ihre Steckrichtung vorzugsweise federnd verdreht (verdrillt) werden, um völlig in die schlitzförmigen Kontakt-Gegenstücke 21 eingesteckt werden zu können. Dadurch ergibt sich an den jeweils in Längsrichtung einer jeden schlitzförmigen Kontaktstelle 21a entfernt voneinander und an den gegenüberliegenden Seitenbegrenzungen ausgebildeten Auflaufund Klemmflächen 25 ein eindeutiger reproduzierbarer elektrischer Kontakt zwischen dem jeweiligen eingesteckten zungenförmigen Vorsprung 23 und des entsprechenden Kontakt-Gegenstückes 21 am Gehäuse in Form von schlitzförmigen Aufnahmeeinrichtungen 21'.

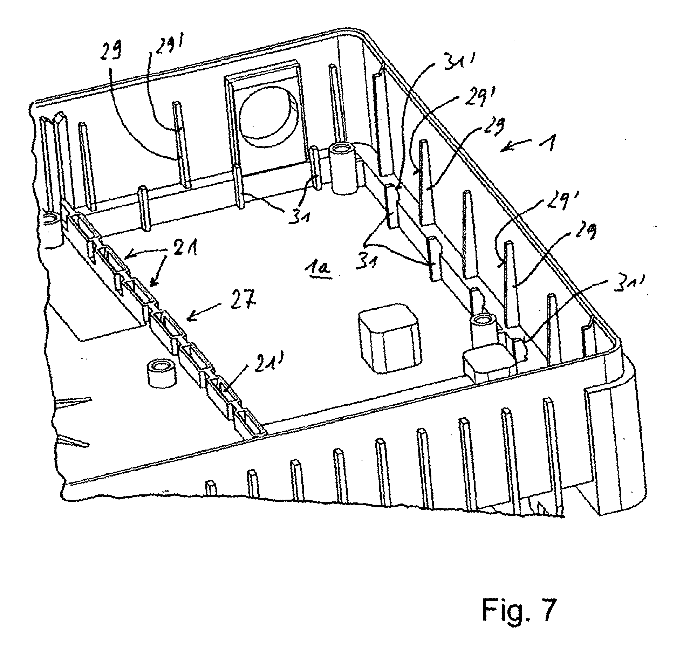

Die in Figur 4 gezeigten, längs einer Linie angeordneten gehäuseseitigen schlitzförmigen Kontaktstellen 21 stellen gleichzeitig eine gehäuseinnenseitige Gehäuse-Schirmwand 27 dar, wie dies aus Figur 7 zu ersehen ist. Bei zuvor einegelegter Leiterplatine 5 und aufgesetztem Abschirmgehäuse 11 führt dies dazu, dass der Innenraum unter der Abschirmhaube 11, also nicht nur der Raum unter der Abschirmhaube 11, der oberhalb der Leiterplatine 5 angeordnet ist, sondern der dazu auch deckungsgleiche Raum unterhalb der Leiterplatine vom restlichen Innenraum des Gehäuses 1 abgeschirmt ist. Dabei wirken die als GehäuseInnenwand 27 wirkenden Kontaktstellen als untere Abschirmwand. Die restlichen Wände des Abschirmgehäuses sind mit den verbleibenden Innenwänden des Gehäuses 1 elektrisch kontaktiert, so dass der gesamte Raum unterhalb des Abschirmgehäuses 11 bis zum Boden 1a des Gehäuses 1 gegenüber dem verbleibenden Innenraum des Gehäuses geschirmt ist.

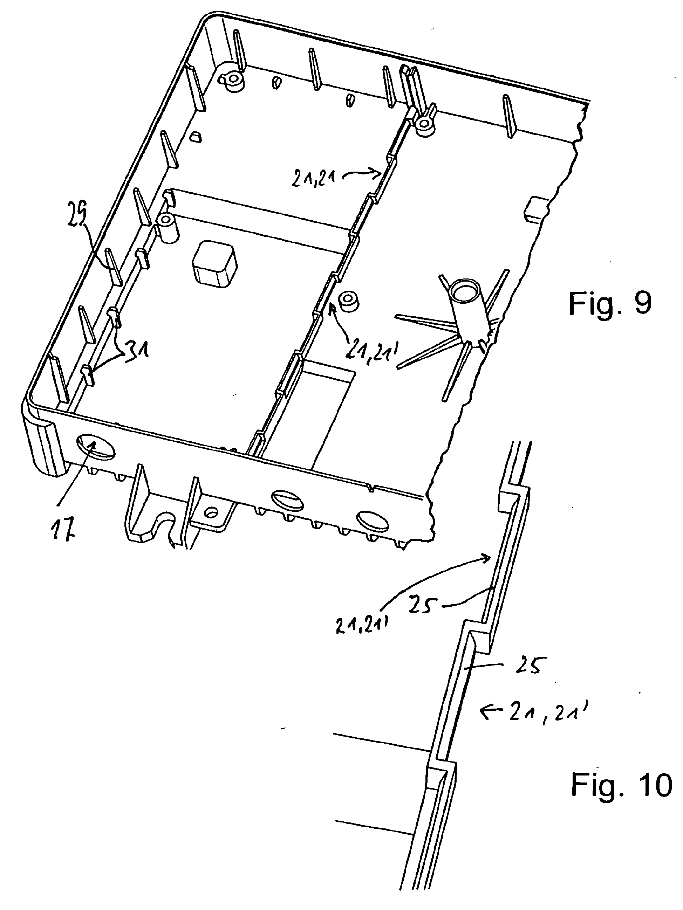

Im gezeigten Ausführungsbeispiel sind also die anderen drei Seitenwände der Abschirmhaube, d.h. die gegenüberliegende größere Seitenwand 11'a sowie die beiden Stirnseitenwände 11b und 11'b so ausgebildet, dass sie unmittelbar innen benachbart neben den Außen- oder Seitenwänden des Gehäuses 1 zu liegen kommen, und zwar derart, dass die stirnseitige Seitenwand 11b der Abschirmhaube 11 benachbart zur größeren Seitenwand 1a des Gehäuses zu liegen kommt, die kleinere Stirnseitenwand 11'b benachbart zur gegenüberliegenden Seitenwand 1'a des Gehäuses und die gegenüberliegend zu der mit den Kontakt-Vorsprüngen 23 vorgesehenen Seitenwand 11'a benachbart zur stirnseitigen Seitenwand 1b des Gehäuses zu liegen kommt. Um auch hier eine gute Kontaktwirkung zu erzielen, müssen keine separaten Zungen oder sonstigen Kontakt-Vorsprünge 23 am unteren Umlaufrand der Abschirmhaube 11 ausgebildet sein, obgleich auch eine solche Lösung realisierbar wäre. In diesem Falle müssten an den Innenwänden des Gehäuses 1 überall die zuvor erläuterten schlitzförmigen Kontaktstellen 21 am Gehäuse 1 ausgebildet sein, um eine derartig ausgebildete Abschirmhaube 11 mit umlaufend vorgesehenen Vorsprüngen jeweils gut kontaktierend im Gehäuse 1 einzusetzen. Im gezeigten Ausführungsbeispiel ist davon abweichend vorgesehen, dass in regelmäßigen Abständen an den Innenseiten der Seitenwände des Gehäuses 1 von oben nach unten, also zum Boden 1a des Gehäuses 1 mit schräger Auflauffläche 29' zunehmend mehr nach innen vorstehend, Rippen 29 vorgesehen sind, wobei jeweils zwischen zwei Rippen benachbart eine sich vom Boden 1a des Gehäuses 1 nur in geringem Maß nach oben erstreckende Gegenrippe 31 oder ein Gegensteg 31 ausgebildet ist, der mit umgekehrt ausgerichteter Auflaufflanke 31' von oben nach unten zunehmend mehr auf die ihm zugewandt liegende Innenseite der jeweiligen Wand des Gehäuses 1 zuläuft (Figur 7). Wie sich insbesondere aus der entsprechenden Draufsicht gemäß Figur 8 ergibt, hat dies zur Folge, dass bei Aufstecken der Abschirmhaube 11 die entsprechenden Seitenwände der Abschirmhaube 11 mit den aufeinander zu verlaufenden Auflaufflächen 29' bzw. 31' wechselwirken und jeweils zumindest in geringfügigem Maße die Wandabschnitte der Abschirmhaube 11 in der einen und über die benachbarte nächste Rippe in der anderen Richtung ein- bzw. ausgebaucht wird, um mit entsprechender Abstandsfolge zwischen den außen sitzenden Rippen 29' und den innen sitzenden Gegenrippen 31 jeweils eindeutige reproduzierbare elektrische Kontaktstellen zu gewährleisten.

Alle erwähnten elektrischen Kontaktstellen einschließlich der erläuterten Kontaktstellen unter Verwendung der zungenförmigen Vorsprünge an der Abschirmhaube und der schlitzförmigen Kontaktstellen 21 im Bereich des Bodens 1c des Gehäuses sind so ausgebildet, dass der Abstand kleiner ist als λₘₐₓ/20, wobei λₘₐₓ die maximale Wellenlänge darstellt, bezüglich derer die Schirmung noch wirksam sein soll.

Anhand von Figur 9 und 10 ist eine Modifikation bezüglich der Kontakt-Gegenstücke 21 bzw. oder Kontaktstellen 21a gezeigt. Diese sind nur an einer Längsseite jeweils mit einer vorzugsweise über die gesamte Länge des Aufnahmeabschnittes der Kontaktstellen 21 mit einer jeweils schrägen Auflauffläche 25 versehen, die aber pro Kontaktstelle 21 jeweils nur in eine Richtung von oben in Richtung Boden 1a zunehmend breiter werdend verläuft. Die Auflauf- und Klemmfläche 25 einer jeweils benachbarten nächsten Kontaktstelle 21 ist dann in der anderen Richtung von oben nach unten schräg verlaufend ausgerichtet, so dass beim Aufsetzen der zugehörigen Kontakt-Vorsprünge 23 am unteren Steckrand der Abschirmhaube 11 die mit den Kontaktstellen 21 wechselwirkenden Kontakt-Vorsprünge 23 nicht in Steckrichtung leicht verdreht werden, sondern wechselweise in der einen und in der anderen Richtung quer zur Ebene der Kontakt-Vorsprünge zunehmend ausgelenkt werden, um einen guten elektrischen Kontakt zu gewährleisten.

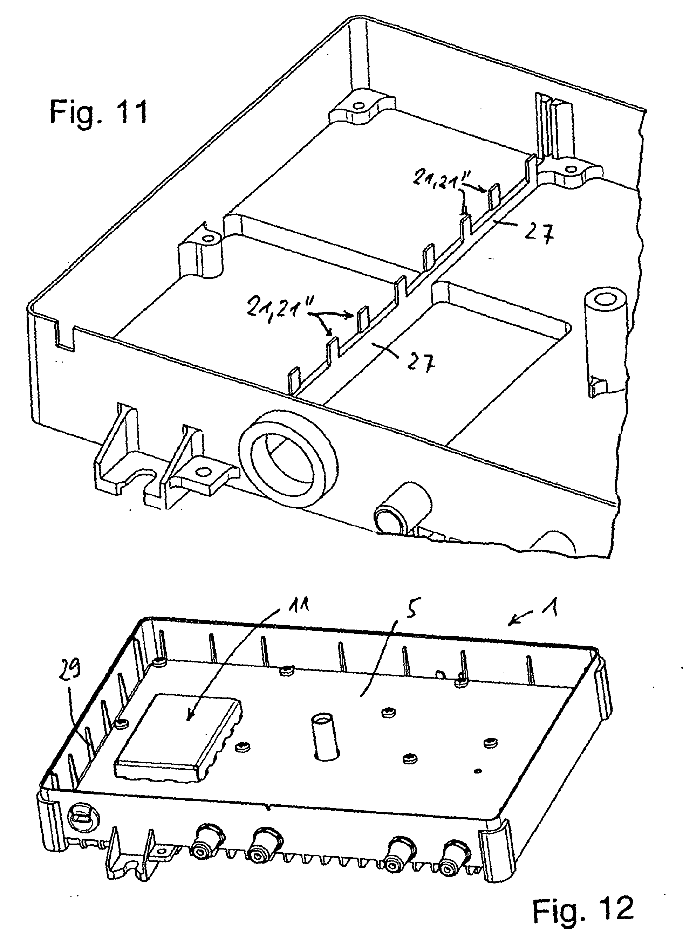

Anhand von Figur 11 ist insoweit ein abweichendes Ausführungsbeispiel gezeigt, als hier die gehäuseseitigen, d.h. im Innenraum des Gehäuses 1 vorgesehenen Kontakt-Gegenstücke 21 unter Ausbildung von Kontaktstellen 21, an einer inneren Gehäuse-Schirmungswand 27 nach oben vorstehend vorgesehen sind, die dann entsprechende schlitzförmige Ausnehmungen 13 in der Leiterplatine 5 nach oben hin durchragen. Wie aus der Darstellung gemäß Figur 11 zu ersehen ist, sind jeweils zwei benachbart zueinander liegende nach oben vorstehende Kontaktstellen-Vorsprünge 21" mit Querkomponente quer zu ihrer Längserstreckung, also quer zur Gehäuse-Schirmungswand 27 versetzt positioniert. Auch bei diesem Ausführungsbeispiel durchragen die Kontaktstellen-Vorsprünge 21" von unten her die entsprechenden Ausnehmungen 13 in einer in das Gehäuse 1 eingeführten Leiterplatine 5, wobei dann die ohne Kontaktvorsprünge ausgebildete Seitenwand 11a der Abschirmhaube 11 von oben her aufgesetzt werden kann. Die Seitenwand 11a wird dabei auf die Kontaktstellen-Vorsprünge 21" so aufgesteckt, dass jeweils ein Kontaktvorsprung 21" innerhalb der Abschirmhaube 11 liegt und bevorzugt der jeweils nächste Kontaktstellen-Vorsprung 21" außerhalb der Seitenwand 11a der Abschirmhaube 11a. Die Wirkungsweise ist dabei ähnlich den oben erläuterten Rippen und Gegenrippen 29, 31, zwischen denen die entsprechende Gehäuse- wand bzw. der entsprechende Gehäusewandabschnitt der Abschirmhaube 11 eingefügt wird, um die elektrisch wirksame Kontaktierung zu gewährleisten.

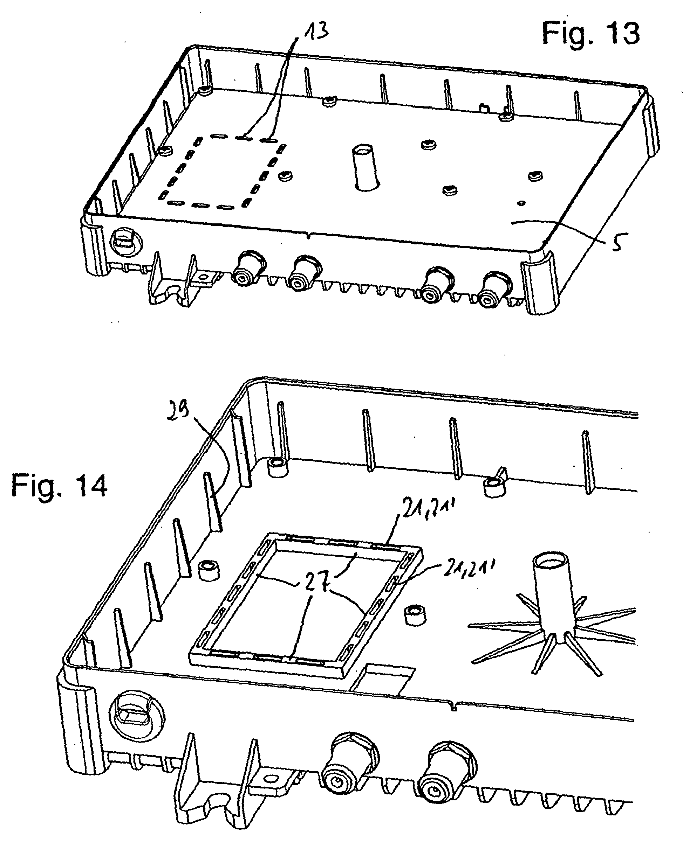

Anhand der Figuren 12 bis 14 ist nur für das Ausführungsbeispiel gemäß den Figuren 1 bis 6 ergänzend gezeigt, dass nicht nur eine Seitenwand 11a der Abschirmhaube 11 eine Leiterplatine 5 durchdringen muss, sondern dass die Abschirmhaube 11 beispielsweise auch so ausgebildet sein kann, dass ihre vier Seitenwände die Ebene der Leiterplatine 5 durchdringen und mit unterhalb der Leiterplatine vorgesehenen Kontaktstellen 21 kontaktiert sind. Dabei können alle Seitenwände der Abschirmhaube 11, die bevorzugt zungen- oder laschenförmigen Vorsprünge 23 aufweisen, die die entsprechenden schlitzförmigen Ausnehmungen in der Leiterplatine 5 durchragen und mit entsprechend schlitzförmigen oder vergleichbar ausgebildeten zum Gehäuse 1 gehörenden und unterhalb der Leiterplatine 5 liegenden Gegenstücke 21" bzw. Kontaktstellen 21 in Wechselwirkung treten. Ebenso können aber Kontaktstellen-Vorsprünge 21 vorgesehen sein, die von unten her die entsprechenden Ausnehmungen in der Leiterplatine 5 nach oben hin durchdringen, so dass dann von oben her die Abschirmhaube aufgesetzt werden kann. Ebenso kann die Wirkungsweise auch wechselweise sein, wonach nämlich ein Teil der Kontaktvorsprünge am unteren Rand der Abschirmhaube 11 ausgebildet sind, und ein anderer Teil der Kontakt-Vorsprünge 21" Teil der Gehäuseinnenseite sind und von unten her durch die aufgesetzte Leiterplatine 5 hindurch gesteckt werden. Die jeweilige Gegenkontakteinrichtung kann so ausgebildet sein, wie dies anhand der Ausführungsbeispiele erläutert wurde.

Durch dieses Ausführungsbeispiel wird also eine Lösung geschaffen, indem der Raum unterhalb der Abschirmhaube 11 vom restlichen Innenraum des an sich schon geschirmten Gehäuses 1 nochmals in geschirmter Weise abgetrennt ist, wobei sich eine geschirmte Kammer oberhalb der Leiterplatine wie aber auch unterhalb der Leiterplatine im Bereich der Abschirmhaube 11 ergibt.

Um beispielsweise bei dem Ausführungsbeispiel gemäß Fig. 1 ff. im Bereich einer Durchtrittsöffnung 41 in der Abschirmhaube 11 eine gute elektrische Kontaktierung zu dem Gehäuse 1 zu erzielen, sind benachbart zu der Durchtrittsöffnung 41 in der Wand 11b des Abschirmgehäuses noch winklig aus der Ebene der Wand 11b nach außen vorstehende Kontaktbereiche 43 durch Kanten und Biegen hergestellt. Bei eingesetzter Abschirmhaube 11 wird hierüber ein federnder Kontakt zur Innen-Oberfläche der angrenzenden Innenseite der Gehäusewand 1a hergestellt.

Schließlich wird der Vollständigkeit halber auch noch erwähnt, dass an der Wand 11a der Abschirmhaube 11 ebenfalls noch kleiner dimensionierte Durchbrüche 47 ausgebildet sein können, um dort beispielsweise ein Durchführungsfilter zu platzieren. Über das Durchführungsfilter kann dann eine elektrische Verbindung von einem beispielsweise unter der Abschirmhaube 11 befindlichen Netzteil zu den elektrischen Baukomponenten benachbart zur Abschirmhaube 11 auf der Platine 5 hergestellt werden. Werden beispielsweise mehrere unterschiedliche Gleichstromspannungen benötigt, so kann vom Netzteil ausgehend über mehrere, versetzt liegende Durchbrüche und Duchführungsfilter eine entsprechende störungsfreie Gleichstrom-Spannungsversorgung hergestellt werden.

Das Abschirmgehäuse ist bevorzugt als einteiliges Stanzteil hergestellt. Die Seitenwände werden also durch Abkantung um 90° gegenüber der oberen Deckfläche der Abschirmhaube hergestellt. Zwei benachbarte Seitenwände 11a und 11b sowie die weiteren Seitenwände sind also von daher untereinander nicht verbunden. Durch Einbringen von kleinen Laschen, die zur nächsten benachbarten Seitenwand umgelegt werden, können Kontakte, d.h. Berührungsstellen jeweils zwischen zwei benachbarten Seitenwänden hergestellt werden. Eine gute elektrische Verbindung wird durch umgelegte Zapfen, d.h. allgemein durch Umlegen, Verdrillen, Stanznieten, Durchsetzfügen oder/und ein anderes umformtechnisches Fügeverfahren erzielt. Diese Zapfen 51 sind beispielsweise in Figur 5a und 5b eingezeichnet. Bevorzugt umfasst das erläuterte Gerät ein Netzteil und eine HF-Schaltung auf einer gemeinsamen Leiterplatine, wobei das Netzteil wie erläutert unter der separaten Abschirmhaube 11 untergebracht ist.

## Patentansprüche

1. Elektrisches Gerät mit folgenden Merkmalen
- mit einer Gehäuseanordnung mit einem Gehäuse (1) und einem das Gehäuse (1) verschließenden Deckel (3),
- zumindest das Gehäuse (1) besteht aus einem Gussteil, welches aus elektrisch leitfähigem Material besteht oder mit einer elektrisch leitfähigen Oberflächenschicht versehen ist,
- im Innenraum der Gehäuseanordnung ist eine Leiterplatine (5) mit elektrischen Bauteilen und Baukomponenten vorgesehen, wobei die Leiterplatine (5) mit dem Gehäuse (1) elektrisch leitend verbunden ist, und
- im Inneren der Gehäuseanordnung ist ein zusätzlich hochfrequenzmäßig abgeschirmter Raum vorgesehen, der zum Teil oberhalb und zum Teil unterhalb der Leiterplatine (5) angeordnet ist,
- der zusätzlich abgeschirmte Raum umfasst eine Abschirmhaube (11), die auf einer Seite der Leiterplatine (5) aufsetzbar ist,
- zumindest eine Seitenwand (11a) oder ein Abschnitt der Seitenwand (11a) der Abschirmhaube (11) weist Vorsprünge (23) auf, die durch in der Leiterplatine (5) ausgebildete Ausnehmungen (13) hindurchragen,
- auf der zur Abschirmhaube (11) gegenüberliegenden Seite der Leiterplatine (5) ist zumindest eine Schirmungswand (27) vorgesehen,
**gekennzeichnet durch** die folgenden weiteren Merkmale
- die auf der zur Abschirmhaube (11) gegenüberliegende Seite der Leiterplatine (5) vorgesehene Schirmungswand (27) ist als zum Gehäuse (1) gehörende oder damit verbundene Gehäuse-Schirmungswand (27) ausgebildet,
- an der Gehäuse-Schirmungswand (27) oder zumindest einem Abschnitt davon sind Kontakt-Gegenstücke (21) ausgebildet,
- die Vorsprünge (23) und die Kontakt-Gegenstücke (21) sind miteinander elektrisch kontaktiert, und
- die Vorsprünge (23) und die mit ihnen kontaktierten Kontakt-Gegenstücke (21) sind so ausgebildet oder es ist eine Zusatzeinrichtung so vorgesehen, dass zur Verbesserung der elektrischen Kontaktwirkung auf die Vorsprünge (23) und/oder die Kontakt-Gegenstücke (21) Verformungs- und/oder Kerbkräfte unter Erzeugung von Biege-, Klemm- und/oder Verdrillkräften ausgeübt werden.

2. Elektrisches Gerät mit folgenden Merkmalen
- mit einer Gehäuseanordnung mit einem Gehäuse (1) und einem das Gehäuse (1) verschließenden Deckel (3),
- zumindest das Gehäuse (1) besteht aus einem Gussteil, welches aus elektrisch leitfähigem Material besteht oder mit einer elektrisch leitfähigen Oberflächenschicht versehen ist,
- im Innenraum der Gehäuseanordnung ist eine Leiterplatine (5) mit elektrischen Bauteilen und Baukomponenten vorgesehen, wobei die Leiterplatine (5) mit dem Gehäuse (1) elektrisch leitend verbunden ist, und
- im Inneren der Gehäuseanordnung ist ein zusätzlich hochfrequenzmäßig abgeschirmter Raum vorgesehen, der zum Teil oberhalb und zum Teil unterhalb der Leiterplatine (5) angeordnet ist,
- der zusätzlich abgeschirmte Raum umfasst eine Abschirmhaube (11), die auf einer Seite der Leiterplatine (5) aufsetzbar ist,
- auf der zur Abschirmhaube (11) gegenüberliegenden Seite der Leiterplatine (5) ist zumindest eine Schirmungswand (27) vorgesehen,
- die zumindest eine Schirmungswand (27) oder ein Abschnitt der Schirmungswand (27) weist Vorsprünge (21") auf, die durch in der Leiterplatine ausgebildete Ausnehmungen (13) hindurchragen
**gekennzeichnet durch** die folgenden weiteren Merkmale
- die auf der zur Abschirmhaube (11) gegenüberliegenden Seite der Leiterplatine (5) vorgesehene Schirmungswand (27) ist als zum Gehäuse (1) gehörende oder damit elektrisch verbundene Gehäuse-Schirmungswand (27) ausgebildet,
- an der Abschirmhaube (11) sind Kontakt-Gegenstücke oder Kontaktstellen ausgebildet, die mit den Vorsprüngen (21") elektrisch kontaktiert sind und
- die Vorsprünge (21") und die Kontakt-Gegenstücke sind so ausgebildet oder es ist eine Zusatzeinrichtung so vorgesehen, dass zur Verbesserung der elektrischen Kontaktwirkung auf die Vorsprünge (21") und/oder die Kontaktstellen Verformungs- und/oder Kerbkräfte unter Erzeugung von Biege-, Klemm- und/oder Verdrillkräften ausgeübt werden.

3. Gerät nach Anspruch 1 oder 2, **dadurch gekennzeichnet, dass** die Vorsprünge (23, 21") aus Kontakt-Zungen, KontaktFlächen, Kontakt-Laschen, Kontakt-Streifen, Kontakt-Stiften, Kontakt-Stäben, Kontakt-Rippen und dergleichen bestehen, die im Abstand zueinander angeordnet sind.

4. Gerät nach einem der Ansprüche 1 bis 3, **dadurch gekennzeichnet, dass** die Kontaktstellen oder Kontakt-Gegenstücke (21) aus Kontaktstellen-Aufnahmen (21') bestehen, in welche die Vorsprünge (23, 21") im montierten Zustand eingesteckt sind.

5. Gerät nach einem der Ansprüche 1 bis 4, **dadurch gekennzeichnet, dass** die gehäuseseitigen oder die abschirmhaubenseitigen Kontakt-Gegenstücke (21) mit Aufnahmeräumen (21') für die Vorsprünge (23, 21") versehen sind, und dass ein Aufnahmeraum (21') mit zumindest einer von oben nach unten schräg verlaufenden Auflauf- oder Klemmfläche (25) ausgestattet ist.

6. Gerät nach einem der Ansprüche 1 bis 5, **dadurch gekennzeichnet, dass** die schlitzförmigen Kontakt-Gegenstücke (21, 23") in Längsrichtung versetzt liegende Auflauf- und/oder Klemmflächen (25) aufweisen, die in entgegengesetzter Richtung ausgerichtet sind, und die von oben her in Einsteckrichtung nach unten hin so schräg verlaufen, dass beim Einstecken die Vorsprünge (23, 21") vorzugsweise federnd verformt, verbogen, ausgelenkt und/oder verdrillt werden.

7. Gerät nach Anspruch 6, **dadurch gekennzeichnet, dass** jeweils ein Kontakt-Gegenstück (21, 23") eine Auflauf- oder Klemmfläche (25) aufweist.

8. Gerät nach Anspruch 7, **dadurch gekennzeichnet, dass** zwei benachbart zueinander liegende Kontakt-Gegenstücke (21) mit zumindest je einer rampenförmigen Auflauf- und Klemmfläche (25) versehen sind, die in entgegengesetzte Richtung ausgerichtet sind.

9. Gerät nach einem der Ansprüche 1 bis 8, **dadurch gekennzeichnet, dass** die Kontakt-Vorsprünge (23) kammartig gestaltet sind.

10. Gerät nach einem der Ansprüche 1 bis 9, **dadurch gekennzeichnet, dass** jeweils die von unten nach oben durch die Leiterplatinenebene hindurchragenden und zur Schirmungswand (27) gehörenden Vorsprünge (21") zumindest teilweise gegenüber einer Vertikalebene mit Querversatz versetzt angeordnet sind, und zwar unter Bildung eines Steckaufnahmeraumes derart, dass bei aufgesteckter Abschirmhaube (11) ein Teil der nach oben vorragenden Vorsprünge (21") innerhalb der Abschirmhaube (11) und ein anderer Teil außerhalb der Abschirmhaube (11) zu liegen kommen und jeweils in Richtung des dazwischen befindlichen Wandabschnittes der Abschirmhaube (11) Druckkräfte hierauf ausgeübt werden bzw. der entsprechende Wandabschnitt der Abschirmhaube (11) vorzugsweise federnd verformt wird.

11. Gerät nach einem der Ansprüche 1 bis 10, **dadurch gekennzeichnet, dass** zumindest zwei Seitenwände oder Seitenwandabschnitte (11a), vorzugsweise zumindest drei Seitenwände oder Seitenwandabschnitte oder mehr, insbesondere alle Seitenwände (11a) der Abschirmhaube (11) die Ebene der Leiterplatine (5) nach unten hin durchdringen und/oder mit von unterhalb der Leiterplatine (5) ausgehenden und zum Gehäuse (1) gehörenden und bis oberhalb der Leiterplatinen-Ebene nach oben vorstehenden Vorsprüngen (21") wechselwirken.

12. Gerät nach einem der Ansprüche 1 bis 11, **dadurch gekennzeichnet, dass** zumindest eine Seitenwand oder ein Seitenwandabschnitt (11a), vorzugsweise maximal drei Seitenwände oder Seitenwandabschnitte, mit entsprechenden Seitenwänden (1a, 1b) des Gehäuses (1) kontaktiert sind.

13. Gerät nach Anspruch 12, **dadurch gekennzeichnet, dass** an den Innenseiten des Gehäuses (1) zusätzliche Kontakteinrichtungen, vorzugsweise in Form von versetzt zueinander liegenden und die Seitenwände oder Seitenwandabschnitte (11a) der Abschirmhaube (11) dazwischen aufnehmende Rippen (29) und Gegenrippen (31) vorgesehen sind, worüber das Gehäuse (1) mit der Abschirmhaube (11) in diesen Bereichen elektrisch kontaktiert ist.

14. Gerät nach einem der Ansprüche 1 bis 13, **dadurch gekennzeichnet, dass** im Bereich der Abschirmhaube (11) zumindest ein Kabeldurchbruch (47) in einer Seitenwand vorgesehen ist, zu dem benachbart eine elektrisch aus der Wandebene vorstehende Kontaktiereinrichtung ausgebildet ist, die mit der Innenseite des Gehäuses (1) im montierten Zustand elektrisch kontaktierbar ist.

15. Gerät nach einem der Ansprüche 1 bis 14, **dadurch gekennzeichnet, dass** in zumindest einer Wand der Abschirmhaube (11) eine Öffnung für einen an der Leiterplatine sitzenden Durchführungsfilter vorgesehen ist, worüber eine elektrische Verbindung von Bauteilen unterhalb der Abschirmhaube (11) zu dem Raum außerhalb der Abschirmhaube (11) im Gerät (1) herstellbar ist.

16. Gerät nach einem der Ansprüche 1 bis 15, **dadurch gekennzeichnet, dass** unter der Abschirmhaube (11) ein Netzteil vorgesehen ist, und dass im Gerät außerhalb der Abschirmhaube (11) eine HF-Schaltung auf einer gemeinsamen Leiterplatine mit dem Netzteil angeordnet ist.

17. Gerät nach einem der Ansprüche 1 bis 16, **dadurch gekennzeichnet, dass** dass zumindest zwei Seitenwände oder Seitenwandabschnitte (11a), vorzugsweise zumindest drei Seitenwände oder Seitenwandabschnitte oder mehr, insbesondere alle Seitenwände (11a) der Abschirmhaube (11) die Ebene der Leiterplatine (5) nach unten hin durchdringen und/oder mit von unterhalb der Leiterplatine (5) ausgehenden und zum Gehäuse (1) gehörenden und bis oberhalb der Leiterplatinen-Ebene nach oben vorstehenden Kontaktstellen-Vorsprüngen (21") wechselwirken.

18. Gerät nach einem der Ansprüche 1 bis 17, **dadurch gekennzeichnet, dass** die Abschirmhaube (11) aus einem Blechteil, vorzugsweise einem einteiligen Stanzteil besteht.

19. Gerät nach einem der Ansprüche 1 bis 18, **dadurch gekennzeichnet, dass** die Vorsprünge (23, 21") und/oder die Kontakt-Gegenstücke (21) einen seitlichen Abstand voneinander aufweisen, der kleiner ist als λₘₐₓ/20, wobei λₘₐₓ die maximale Wellenlänge darstellt bis zu der die Schirmung wirksam ist.

## Claims

1. Electrical appliance having the following features:
- having a housing arrangement with a housing (1) and a cover (3) which closes the housing (1),
- at least the housing (1) is in the form of a casting which is composed of electrically conductive material or is provided with an electrically conductive surface layer,
- a printed circuit board (5) is provided in the interior of the housing arrangement, has electrical parts and components and is electrically conductively connected to the housing (1), and
- an area which is additionally radio-frequency-screened is provided in the interior of the housing arrangement, with part of it being arranged above the printed circuit board (5), and part below it,
- the additionally screened area comprises a screening shroud (11) which can be placed on one face of the printed circuit board (5),
- at least one side wall (11a) or one section of the side wall (11a) of the screening shroud (11) has projections (23) which pass through recesses (13) formed in the printed circuit board (5),
- at least one screening wall (27) is provided on the face of the printed circuit board (5) opposite the screening shroud (11),
**characterized by** the following further features:
- the screening wall (27) which is provided on the side of the printed circuit board (5) opposite the screening shroud (11) is in the form of a housing screening wall (27) which is associated with or is connected to the housing (1),
- contact mating pieces (21) are formed on the housing screening wall (27), or at least on a section of it,
- the projections (23) and the contact mating pieces (21) make electrical contact with one another, and
- the projections (23) and the contact mating pieces (21) which make contact with them are designed, or an additional device is provided, such that deformation and/or notch-formation forces are exerted on the projections (23) and/or on the contact mating pieces (21), resulting in the production of bending, clamping and/or twisting forces, in order to improve the electrical contact effect.

2. Electrical appliance having the following features:
- having a housing arrangement with a housing (1) and a cover (3) which closes the housing (1),
- at least the housing (1) is in the form of a casting which is composed of electrically conductive material or is provided with an electrically conductive surface layer,
- a printed circuit board (5) is provided in the interior of the housing arrangement, has electrical parts and components and is electrically conductively connected to the housing (1), and
- an area which is additionally radio-frequency-screened is provided in the interior of the housing arrangement, with part of it being arranged above the printed circuit board (5), and part below it,
- the additionally screened area comprises a screening shroud (11) which can be placed on one face of the printed circuit board (5),
- at least one screening wall (27) is provided on the face of the printed circuit board (5) opposite the screening shroud (11),
- the at least one screening wall (27) or a section of the screening wall (27) has projections (21") which pass through recesses (13) which are formed in the printed circuit board,
**characterized by** the following further features:
- the screening wall (27) which is provided on the side of the printed circuit board (5) opposite the screening shroud (11) is in the form of a housing screening wall (27) which is associated with or is electrically connected to the housing (1),
- contact mating pieces or contact points which make electrical contact with the projections (21") are formed on the screening shroud (11), and
- the projections (21") and the contact mating pieces are designed, or an additional device is provided, such that deformation and/or notch-formation forces are exerted on the projections (21") and/or on the contact points, with bending, clamping and/or twisting forces being produced, in order to improve the electrical contact effect.

3. Appliance according to Claim 1 or 2, **characterized in that** the projections (23, 21") are formed from contact tongues, contact surfaces, contact lugs, contact strips, contact pins, contact rods, contact ribs and the like, which are arranged at a distance from one another.

4. Appliance according to one of Claims 1 to 3, **characterized in that** the contact points or contact mating pieces (21) are formed from contact point holders (21') into which the projections (23, 21") are inserted in the installed state.

5. Appliance according to one of Claims 1 to 4, **characterized in that** the contact mating pieces (21) on the housing side or on the screening shroud side are provided with holding areas (21') for the projections (23, 21") and **in that** one holding area (21') is equipped with at least one inclined or clamping surface (25) which runs obliquely from top to bottom.

6. Appliance according to one of Claims 1 to 5, **characterized in that** the contact mating pieces (21, 23"), which are in the form of slots, have inclined and/or clamping surfaces (25) which are offset in the longitudinal direction, are aligned in the opposite direction and run obliquely from top to bottom in the insertion direction such that the projections (23, 21") are preferably elastically deformed, bent, deflected and/or twisted during insertion.

7. Appliance according to Claim 6, **characterized in that** each contact mating piece (21, 23") has an inclined or clamping surface (25).

8. Appliance according to Claim 7, **characterized in that** two mutually adjacent contact mating pieces (21) are each provided with at least one inclined and clamping surface (25), with these surfaces being in the form of ramps and being aligned in the opposite direction.

9. Appliance according to one of Claims 1 to 8, **characterized in that** the contact projections (23) are in the form of combs.

10. Appliance according to one of Claims 1 to 9, **characterized in that** the projections (21") which pass through the printed circuit board plane from top to bottom and are associated with the screening wall (27) are each arranged at least partially offset with respect to a vertical plane with a lateral offset, to be precise forming a plug holding area, **in that**, when the screening shroud (11) is plugged on, some of the projections (21") which project upwards come to rest within the screening shroud (11) while others come to rest outside the screening shroud (11), and compressive forces are in each case exerted on the wall section of the screening shroud (11) located between them, and **in that** direction, and/or the corresponding wall section of the screening shroud (11) is preferably elastically deformed.

11. Appliance according to one of Claims 1 to 10, **characterized in that** at least two side walls or side wall sections (11a) preferably at least three side walls or side wall sections or more, in particular all of the side walls (11a) of the screening shroud (11) pass downwards through the plane of the printed circuit board (5), and/or interact with projections (21") which originate from underneath the printed circuit board (5), are part of the housing (1) and project upwards to above the printed circuit board plane.

12. Appliance according to one of Claims 1 to 11, **characterized in that** at least one side wall or one side wall section (11a), and preferably a maximum of three side walls or side wall sections, make contact with corresponding side walls (1a, 1b) of the housing (1).

13. Appliance according to Claim 12, **characterized in that** additional contact devices are provided on the inner faces of the housing (1), preferably in the form of ribs (29) and mating ribs (31) which are offset with respect to one another and hold the side walls or side wall sections (11a) of the screening shroud (11) between them, via which the housing (11) makes electrical contact with the screening shroud (11) in these areas.

14. Appliance according to one of Claims 1 to 13, **characterized in that** at least one cable aperture (47) is provided in one side wall in the area of the screening shroud (11), adjacent to which a contact-making device is formed which projects electrically out of the wall plane and can make electrical contact with the inner face of the housing (1) in the installed state.

15. Appliance according to one of Claims 1 to 14, **characterized in that** an opening for a bushing filter which is seated on the printed circuit board is provided in at least one wall of the screening shroud (11), via which opening an electrical connection can be produced between components underneath the screening shroud (11) and the area outside the screening shroud (11) in the appliance (1).

16. Appliance according to one of Claims 1 to 5, **characterized in that** a power supply unit is provided underneath the screening shroud (11), and **in that** an RF circuit is arranged on a common printed circuit board with the power supply unit outside the screening shroud (11) in the appliance.

17. Appliance according to one of Claims 1 to 16, **characterized in that** at least two side walls or side wall sections (11a), preferably at least three side walls or side wall sections or more, and in particular all of the side walls (11a) of the screening shroud (11) pass downwards through the plane of the printed circuit board (5), and/or interact with contact-point projections (21") which originate from underneath the printed circuit board (5), are part of the housing (1) and project upwards to above the printed circuit board plane.

18. Appliance according to one of Claims 1 to 17, **characterized in that** the screening shroud (11) is formed from a sheet-metal part, preferably an integral stamped part.

19. Appliance according to one of Claims 1 to 18, **characterized in that** the projections (23, 21") and/or the contact mating pieces (21) are at a lateral distance from one another which is less than λₘₐₓ/20, where λₘₐₓ represents the maximum wavelength up to which the screen is effective.

## Revendications

1. Appareil électrique comprenant les éléments suivants :
- un agencement formant boîtier pourvu d'un boîtier (1) et d'un couvercle (3) refermant le boîtier (1),
- au moins le boîtier (1) est constitué d'une pièce de fonderie qui est constituée d'un matériau électriquement conducteur ou pourvue d'une couche de surface électriquement conductrice,
- dans le volume intérieur de l'agencement formant boîtier est prévue une carte à circuits imprimés (5) pourvue d'éléments et de composants électriques, la carte à circuits imprimés (5) étant reliée de façon électriquement conductrice au boîtier (1), et
- à l'intérieur de l'agencement formant boîtier est prévue une chambre blindée en supplément vis-à-vis des hautes fréquences, qui est agencée en partie au-dessus et en partie au-dessous de la carte à circuits imprimés (5),
- la chambre blindée en supplément comprend un capot de blindage (11) qui est susceptible d'être posé sur un côté de la carte à circuits imprimés (5),
- au moins une paroi latérale (11a) ou un tronçon de la paroi latérale (11a) du capot de blindage (11) comprend des saillies (23) qui traversent des évidements (13) ménagés dans la carte à circuits imprimés (5),
- sur le côté de la carte à circuits imprimés (5), opposé au capot de blindage (11), est prévue au moins une paroi de blindage (27),
**caractérisé par** les autres éléments suivants :
- la paroi de blindage (27) prévue sur le côté de la carte à circuits imprimés (5) opposé au capot de blindage (11) est réalisée sous la forme d'une paroi de blindage de boîtier (27) appartenant au boîtier (1) ou reliée à celui-ci,
- des éléments de contact antagonistes (21) sont réalisés sur la paroi de blindage de boîtier (27) ou au moins sur un tronçon de celle-ci,
- les saillies (23) et les éléments de contact antagonistes (21) sont mis en contact électrique mutuel, et
- les saillies (23) et les éléments de contact antagonistes (21) mise en contact avec celles-ci sont réalisés de telle sorte, ou il est prévu un dispositif additionnel de telle sorte que pour améliorer l'effet de mise en contact électrique, des forces de déformation et/ou de cisaillement sont exercées sur les saillies (23) et/ou sur les éléments de contact antagonistes (21), en générant des forces de flexion, de coincement et/ou de torsion.

2. Appareil électrique comprenant les éléments suivants :
- un agencement formant boîtier pourvu d'un boîtier (1) et d'un couvercle (3) refermant le boîtier (1),
- au moins le boîtier (1) est constitué d'une pièce de fonderie qui est constituée d'un matériau électriquement conducteur ou pourvue d'une couche de surface électriquement conductrice,
- dans le volume intérieur de l'agencement formant boîtier est prévue une carte à circuits imprimés (5) pourvue d'éléments et de composants électriques, la carte à circuits imprimés (5) étant reliée de façon électriquement conductrice au boîtier (1), et
- à l'intérieur de l'agencement formant boîtier est prévue une chambre blindée en supplément vis-à-vis des hautes fréquences, qui est agencée en partie au-dessus et en partie au-dessous de la carte à circuits imprimés (5),
- la chambre blindée en supplément comprend un capot de blindage (11) qui est susceptible d'être posé sur un côté de la carte à circuits imprimés (5),
- sur le côté de la carte à circuits imprimés (5), opposé au capot de blindage (11), est prévue au moins une paroi de blindage (27),
- ladite au moins une paroi de blindage (27) ou un tronçon de la paroi de blindage (27) comprend des saillies (21") qui traversent des évidements (13) ménagés dans la carte à circuits imprimés,
**caractérisé par** les autres éléments suivants :
- la paroi de blindage (27) prévue sur le côté de la carte à circuits imprimés (5) opposé au capot de blindage (11) est réalisée sous la forme d'une paroi de blindage de boîtier (27) appartenant au boîtier (1) ou connectée électriquement à celui-ci,
- des éléments de contact antagonistes ou des emplacements de contact sont réalisés sur le capot de blindage (11), qui sont mis en contact électrique avec les saillies (21"), et
- les saillies (21") et les éléments de contact antagonistes sont réalisés de telle sorte, ou il est prévu un dispositif additionnel de telle sorte que pour améliorer l'effet de mise en contact électrique, des forces de déformation et/ou de cisaillement sont exercées sur les saillies (21") et/ou sur les emplacements de contact, en générant des forces de flexion, de coincement et/ou de torsion.

3. Appareil selon l'une ou l'autre des revendications 1 et 2, **caractérisé en ce que** les saillies (23, 21") sont constituées par des languettes de contact, des surfaces de contact, des pattes de contact, des lames de contact, des goupilles de contact, des barreaux de contact, des nervures de contact et similaires, qui sont agencés à distance les uns des autres.

4. Appareil selon l'une des revendications 1 à 3, **caractérisé en ce que** les emplacements de contact ou les éléments de contact antagonistes (21) sont constitués par des logements d'emplacement de contact (21') dans lesquels sont enfichées les saillies (23, 21") dans l'état monté.

5. Appareil selon l'une des revendications 1 à 4, **caractérisé en ce que** les éléments de contact antagonistes (21) côté boîtier ou ceux côté capot de blindage sont pourvus d'espaces de logement (21') pour les saillies (23, 21"), et **en ce qu'**un espace de logement (21') est muni d'au moins une surface de montée ou de coincement (25) qui s'étend en oblique depuis le haut vers le bas.

6. Appareil selon l'une des revendications 1 à 5, **caractérisé en ce que** les éléments de contact antagonistes (21, 23") en forme de fente présentent des surfaces de montée et/ou de coincement (25) décalées dans la direction longitudinale et orientées dans des directions opposées et s'étendent en oblique depuis le haut vers le bas dans la direction d'enfichage, de telle sorte que lors de l'enfichage les saillies (23, 21") sont déformées, fléchies, déviées et/ou torsadées avec effet ressort.

7. Appareil selon la revendication 6, **caractérise en ce qu'**un élément de contact antagoniste (21, 23") respectif présente une surface de montée ou de coincement (25).

8. Appareil selon la revendication 7, **caractérise en ce que** deux éléments de contact antagoniste (21) situés au voisinage l'un de l'autre sont pourvus chacun d'au moins une surface de montée et de coincement (25) en forme de rampe, qui sont orientées dans des directions opposées.

9. Appareil selon l'une des revendications 1 à 8, **caractérisé en ce que** les saillies de contact (23) sont configurées à la manière d'un peigne.

10. Appareil selon l'une des revendications 1 à 9, **caractérisé en ce que** les saillies respectives (21") traversant depuis le bas vers le haut le plan de la carte à circuits imprimés et appartenant à la paroi de blindage (27) sont agencées au moins partiellement avec décalage transversal par rapport à un plan vertical, et ceci en formant un espace de logement par enfichage, **en ce que** dans l'état enfiché du capot de blindage (11) une partie des saillies (21") dépassant vers le haut vient se retrouver à l'intérieur du capot de blindage (11) et une autre partie vient se retrouver à l'extérieur du capot de blindage (11), et des forces de compression sont exercées sur ledit capot dans la direction du tronçon de paroi du capot de blindage (11) situé entre les deux parties, ou le tronçon de paroi correspondant du capot de blindage (11) est déformé de préférence avec effet ressort.

11. Appareil selon l'une des revendications 1 à 10, **caractérisé en ce qu'**au moins deux parois latérales ou tronçons de paroi latérale (11a), de préférence au moins trois parois latérales ou tronçons de paroi latérale ou plus, en particulier toutes les parois latérales (11a) du capot de blindage (11) traversent vers le bas le plan de la carte à circuits imprimés (5) et/ou coopèrent avec des saillies (21") partant depuis le dessous de la carte à circuits imprimés (5) et appartenant au boîtier (1) et dépassant vers le haut jusqu'au-dessus du plan de la carte à circuits imprimés.

12. Appareil selon l'une des revendications 1 à 11, **caractérisé en ce qu'**au moins une paroi latérale ou un tronçon de paroi latérale (11a), de préférence au maximum trois parois latérales ou tronçons de paroi latérale sont mis(es) en contact avec des parois latérales correspondantes (1a, 1b) du boîtier (1).

13. Appareil selon la revendication 12, **caractérisé en ce que** sur les côtés intérieurs du boîtier (1) sont prévus des dispositifs de contact supplémentaires, de préférence sous la forme de nervures (29) ou de nervures antagonistes (31) mutuellement décalées et recevant entre elles les parois latérales ou les tronçons de paroi latérale (11a) du capot de blindage (11), via lesquelles le boîtier (1) peut être mis en contact électrique avec le capot de blindage (11) dans ces zones.

14. Appareil selon l'une des revendications 1 à 13, **caractérisé en ce que** dans la zone du capot de blindage (11) est prévue au moins une traversée à câble (47) dans une paroi latérale, au voisinage de laquelle est réalisé un dispositif de mise en contact dépassant électriquement du plan de paroi, qui est susceptible d'être mis en contact électrique avec le côté intérieur du boîtier (1), dans l'état monté.

15. Appareil selon l'une des revendications 1 à 14, **caractérisé en ce que** dans au moins une paroi du capot de blindage (11) est prévue une ouverture pour un filtre de passage reposant sur la carte à circuits imprimés, via lequel peut s'établir une connexion électrique de composants au-dessous du capot de blindage (11) avec l'espace à l'extérieur du capot de blindage (11) dans l'appareil (1).

16. Appareil selon l'une des revendications 1 à 15, **caractérisé en ce qu'**au-dessous du capot de blindage (11) est prévu un bloc d'alimentation, et **en ce que** dans l'appareil, à l'extérieur du capot de blindage (11), est agencé un circuit haute fréquence sur une carte à circuits imprimés commune avec le bloc d'alimentation.

17. Appareil selon l'une des revendications 1 à 16, **caractérisé en ce qu'**au moins deux parois latérales ou tronçons de paroi latérale (11a), de préférence au moins trois parois latérales ou tronçons de paroi latérale ou plus, en particulier toutes les parois latérales (11a) du capot de blindage (11) traversent vers le bas le plan de la carte à circuits imprimés (5) et/ou coopèrent avec des saillies d'emplacement de contact (21") partant depuis le dessous de la carte à circuits imprimés (5) et appartenant au boîtier (1) et dépassant vers le haut jusqu'au-dessus du plan de la carte à circuits imprimés.

18. Appareil selon l'une des revendications 1 à 17, **caractérisé en ce que** le capot de blindage (11) est constitué d'une pièce en tôle, de préférence d'une pièce poinçonnée d'un seul tenant.

19. Appareil selon l'une des revendications 1 à 18, **caractérisé en ce que** les saillies (23, 21") et/ou les éléments de contact antagonistes (21) présentent mutuellement une distance latérale qui est inférieure à λ, ₘₐₓ/20, λₘₐₓ représentant la longueur d'onde maximale jusqu'à laquelle fait effet le blindage.
